Europäisches Patentamt

European Patent Office

Office européen des brevets

(19)

(11) **EP 0 772 055 B1**

(12) **FASCICULE DE BREVET EUROPEEN**

(45) Date de publication et mention
de la délivrance du brevet:
**25.08.2004 Bulletin 2004/35**

(51) Int Cl.7: **G01R 31/36**

(21) Numéro de dépôt: **96202927.8**

(22) Date de dépôt: **21.10.1996**

(54) **Système de contrôle de la phase de décharge des cycles de charge-décharge d'une batterie rechargeable, et dispositif hôte muni d'une batterie intelligente**

Steuerungssystem der Entladungsphase von Lade-/Entladezyklen einer wiederaufladbaren Batterie und zugehörige Vorrichtung mit einer intelligenten Batterie

System for controlling the discharge phase of charge/discharge cycles of a rechargeable battery and host device including an intelligent battery

(84) Etats contractants désignés:
**DE ES FR GB IT**

(30) Priorité: **31.10.1995 FR 9512863**

(43) Date de publication de la demande:
**07.05.1997 Bulletin 1997/19**

(73) Titulaire: **Koninklijke Philips Electronics N.V.
5621 BA Eindhoven (NL)**

(72) Inventeurs:
- **Patillon, Jean-Noel, Société Civile S.P.I.D.
75008 Paris (FR)**
- **D'Alche-Buc, Florence, Société Civile S.P.I.D.
75008 Paris (FR)**
- **Nadal, Jean-Pierre, Société Civile S.P.I.D.
75008 Paris (FR)**

(74) Mandataire: **Lottin, Claudine et al
Société Civile SPID,
156, Boulevard Haussmann
75008 Paris (FR)**

(56) Documents cités:
**EP-A- 0 420 530          EP-A- 0 505 333
WO-A-90/13823**

- **TENTH E.C. PHOTOVOLTAIC SOLAR ENERGY CONFERENCE. PROC. OF THE INTERNATIONAL CONFERENCE, LISBON, PORTUGAL, 8-12 APRIL 1991, pages 427-430, XP000577575 M. STOLL: "Neural networks - a proper approach to the energy management problem?"**
- **IBM TECHNICAL DISCLOSURE BULLETIN, vol. 29, no. 1, Juin 1986, NEW YORK, US, pages 352-356, XP002008839 ANONYMOUS: "Dynamic Rechargeable Battery End-Of-Life Prediction"**

**Description**

L'invention concerne un système de contrôle de la phase de décharge des cycles de charge-décharge d'une batterie rechargeable, pour former une batterie intelligente.

L'invention concerne également un dispositif hôte équipé d'une batterie intelligente.

L'invention trouve son application dans le domaine des appareils modulaires équipés d'une batterie rechargeable tels que par exemple : les téléphones cellulaires individuels ou professionnels, les outils sans fil, les ordinateurs portables, les jouets....

Par batterie intelligente, on entend généralement une batterie rechargeable, couplée à un système qui contrôle sa quantité de charge. Ce système comporte des moyens pour collecter des données sur la quantité de charge de la batterie, et des moyens pour fournir des informations prédictives calculées concernant les conditions de décharge dans le futur.

Un problème technique pose par la détermination d'informations prédictives sur les conditions de décharge dans le futur, pour une batterie rechargeable, tient à la variabilité des paramètres de construction de la batterie et à la variabilité des habitudes de l'utilisateur du dispositif hôte.

La variabilité des paramètres de construction de la batterie considérée individuellement est due à la dispersion des données de structure en tours de fabrication, pour un même type de batterie.

La variabilité des habitudes de l'utilisateur conduit à des abus qui peuvent endommager la batterie et affecter les possibilités ultérieures de recharge. Ces habitudes abusives comprennent des charges durant un laps de temps trop long, ou des recharges trop fréquentes d'une batterie non substantiellement déchargée.

Un autre problème technique tient aussi au fait que les applications actuelles des batteries rechargeables requièrent une très haute précision portant sur la quantité d'énergie disponible à un moment donné.

Un appareil et une méthode pour prédire la décharge d'une batterie sont déjà connus du brevet EP 0 420 530. Ce document décrit une technique pour prédire la réserve de temps restant avant qu'une batterie ne soit déchargée. Cette technique est basée sur un algorithme d'état de charge adaptatif qui est actif en temps réel pour répondre aux changements de conditions de la batterie. Cet algorithme est basé sur des caractéristiques de décharge mesurées de la batterie dont la réserve de temps doit être prédite. Le nombre des caractéristiques est réduit à deux paramètres déterminés à partir d'une seule courbe avec une région linéaire et une région exponentielle. Ces caractéristiques de décharge sont combinées avec des paramètres dynamiques du système de batterie contrôlés et calculés en temps réel afin de produire une évaluation continuelle et une ré-évaluation de la réserve de temps restant sous des conditions changeantes. Au cours de la décharge, il y a une continuelle amélioration de la prédiction de réserve de temps restant.

Un système de contrôle de la quantité de charge d'une batterie, utilisant un réseau de neurones est déjà connu de la publication intitulée "Neural Network, A proper Approach to the Energy Management Problem", par Marcus STOLL dans "10th European Photovoltaic Solar Energy conference", 8-10 APRIL 1991, LISBON, PORTUGAL, p. 427-430". La publication citée décrit l'utilisation d'un réseau de neurones pour assumer la tâche d'estimer la quantité de charge (SOC) d'une batterie plomb-acide, dans un système de recharge (RES). Selon le document cité, la détermination de la quantité de charge (SOC) est une tâche importante devant être effectuée pour contrôler le niveau d'énergie d'une batterie. En particulier, l'estimation de la quantité de charge permet la planification de l'utilisation de l'énergie renouvelable, l'optimisation des conditions d'utilisation d'un dispositif hôte, la prise de décisions qui concerne les différentes phases des cycles de charge-décharge de la batterie.

Un réseau de neurones est entraîné au moyen d'une base de données, à estimer la quantité de charge (SOC).

Pour réduire le coût, le réseau de neurones est entraîné sur seulement une petite partie du domaine de décharge de la batterie. Comme, durant la plus grande partie du temps, le courant de décharge est très petit, l'entraînement du réseau de neurones est réalise dans ce domaine.

Dans la phase d'apprentissage du réseau de neurones, on utilise une base de données incluant le courant de décharge, la tension de décharge, et la quantité de charge sous conditions standards d'utilisation, c'est-à-dire à température fixe de 20°C, et à courant fixe. En addition, cette base de données peut inclure des informations relatives aux cycles de décharge et profondeur de décharge et à la température moyenne de la batterie. Différents lots de ces données, formant des vecteurs d'entrée, sont fournis au réseau de neurones pour lui apprendre le comportement de décharge des batteries. Le réseau de neurones s'organise pour une représentation appropriée du comportement de la batterie.

Dans la phase de classification du réseau de neurones, on lui fournit seulement le courant et la tension de décharge et il répond en sortie avec la quantité de charge correspondante de la batterie.

Un problème qui résulte de l'utilisation du système connu est que ce système n'est pas en mesure de prédire directement le laps de temps restant avant qu'un seuil critique de tension de décharge ne soit atteint.

Un autre problème qui résulte de l'utilisation du système connu est que les données correspondant au nombre de cycles antérieurs de charges-décharges et à la profondeur des décharges dans ces cycles, ne peuvent pas correctement être prises en compte. En effet, ces données sont éminemment variables en fonction de l'utilisation réelle qui est faite de la batterie en fonctionnement, et influent grandement sur la quantité de charge réelle présente dans la batterie à un instant donné d'un cycle de décharge, alors que, dans le système connu du document cite, les poids du réseau de neurones sont fixes définitivement des la fin de la phase d'apprentissage.

Un but de la présente invention est de fournir un système de contrôle de la phase de décharge des cycles de charge-décharge d'une batterie rechargeable qui fournit des informations prédictives concernant l'instant où un seuil critique prédéterminé de tension de décharge de la batterie sera atteint, et plus particulièrement des informations prédictives concernant le laps de temps restant à courir à partir de chaque instant courant d'utilisation jusqu'à l'instant où ce seuil critique prédéterminé de tension de décharge sera atteint.

Un but de la présente invention est de fournir un système de contrôle de la phase de décharge des cycles de charge-décharge d'une batterie qui fournit de telles informations prédictives qui s'adaptent automatiquement aux nouvelles données de tension qui varient à chaque phase de décharge de la batterie en fonction du nombre de cycles de charge-décharge déjà effectué antérieurement, et en fonction d'un comportement moyen du type de la batterie concernée.

Ces problèmes sont résolus par un système de contrôle de la phase de décharge des cycles de charge-décharge d'une batterie, couplé à une batterie rechargeable ayant des phases de charge alternant avec des phases de décharge selon des cycles de charge-décharge, tel que récité dans la Revendication 1, ce système comprenant :

des premiers moyens de calcul adaptatifs arrangés pour collecter, à un instant initial au commencement d'une phase de décharge d'un cycle de charge-décharge de la batterie, une valeur prédéterminée d'un seuil critique de tension de décharge, et pour calculer et fournir une indication prédictive d'un instant critique où la batterie atteindra ce seuil critique prédéterminé de tension de décharge,
des second moyens de calcul adaptatifs, couplés aux premiers moyens de calcul, arrangés pour collecter, à l'instant initial, une mesure d'une tension initiale, d'une variation initiale de la tension à un nouvel instant après un court laps de temps à partir de cet instant initial, et du nombre initial de cycles de charge-décharge déjà effectués dans cette batterie avant cet instant initial, et pour calculer et fournir, dès l'instant de la phase concernée où les mesures initiales sont disponibles, des paramètres de fonctionnement automatiquement adaptés aux valeurs des mesures initiales, pour imposer aux premiers moyens de calcul.

Ces problèmes sont en particulier résolus par un système tel que défini précédemment, tel que récité dans la Revendication 2, dans lequel les premiers moyens de calcul adaptatifs sont aussi arrangés pour collecter, à un instant courant, dans la phase de décharge considérée du cycle de charge-décharge de la batterie en tours, une mesure de là température, et pour calculer et fournir, à cet instant courant, une indication prédictive d'un instant critique où la batterie atteindra le seuil critique prédéterminé de tension de décharge.

Ces problèmes sont en particulier résolus par l'un ou l'autre des systèmes de contrôle défini précédemment, tel que récité dans la Revendication 3, dans lequel :

les premiers moyens de calcul adaptatifs sont aussi arrangés pour calculer et fournir, à chaque instant courant, une indication prédictive du laps de temps restant à courir à partir de cet instant courant jusqu'à l'instant où la batterie atteindra le seuil critique prédéterminé de tension de décharge.

Dans un mode de réalisation particulier, ces problèmes sont résolus par un système de contrôle tel que défini précédemment, tel que récité dans la Revendication 4, dans lequel les premier et second moyens de calcul adaptatifs sont constitués respectivement par :

un premier réseau de neurones arrangé pour calculer et fournir, à chaque instant courant, à partir du seuil critique prédéterminé de tension de décharge, une indication prédictive du laps de temps restant à courir à partir de cet instant courant jusqu'à l'instant critique où la batterie atteindra le seuil critique prédéterminé de tension de décharge,
un second réseau de neurones monté en série avec le premier réseau de neurones, arrangé pour calculer et fournir, à partir de la mesure des valeurs de tension initiale, de variation initiale de tension et nombre initial de cycles, à chaque commencement de phase de décharge de chaque cycle de décharge, dès l'instant de la phase concernée où les mesures initiales sont disponibles, des coefficients synaptiques automatiquement adaptés pour imposer au premier réseau de neurones.

Dans un autre mode de réalisation particulier, ces problèmes sont résolus par un système de contrôle tel que défini précédemment, tel que récité dans la Revendication 5, dans lequel les premier et second moyens de calcul adaptatifs sont constitués respectivement par :

un premier réseau de neurones arrangé pour calculer et fournir, à chaque instant courant, à partir du seuil critique prédéterminé de tension de décharge, et à partir de la mesure de là température, une indication prédictive du laps de temps restant à courir à partir de cet instant courant jusqu'à l'instant critique où la batterie atteindra ce seuil critique prédéterminé de tension de décharge,

un second réseau de neurones monté en série avec le premier réseau de neurones, arrangé pour calculer et fournir, à partir de la mesure des valeurs de tension initiale, de variation initiale de tension et nombre initial de cycles, à chaque commencement de phase de décharge de chaque cycle de décharge, des l'instant de la phase concernée où les mesures initiales sont disponibles, des poids synaptiques automatiquement adaptés pour imposer au premier réseau de neurones.

L'avantage de ce système de contrôle dans l'un et l'autre de ses modes de réalisation est que les indications prédictives s'adaptent aux caractéristiques individuelles de charge-décharge de la batterie à laquelle ce système de contrôle est appliqué, pour un type de batterie donné; que ces indications prédictives sont très précises et très fiables et qu'elles portent sur une mesure permettant à l'utilisateur de faire fonctionner un dispositif hôte muni de cette batterie "intelligente" dans les meilleures conditions d'utilisation.

Dans un mode d'application de l'invention, tel que récité dans la Revendication 11, un dispositif hôte (130) comprend un tel système de contrôle, ce dispositif hôte étant alimenté par la batterie rechargeable qui est couplée au dit système de contrôle.

L'avantage de ce système est d'être simple à mettre en oeuvre. Le dispositif hôte couplé à ce système est particulièrement performant.

L'invention est décrite ci-après en détail en référence avec les figures schématiques annexées, dont :

la FIG.1A qui représente un premier système de contrôle pour batterie rechargeable, pour constituer un système global appelé batterie intelligente, et la FIG.1B qui représente un second système de contrôle pour batterie rechargeable, pour constituer une batterie intelligente;

la FIG.2A qui représente un premier réseau de neurones NN1A pour le premier système de contrôle, et la FIG. 2B qui représente un second réseau de neurones NN2A pour ce premier système de contrôle;

la FIG.3A qui représente un premier réseau de neurones NN1 B pour un second système de contrôle, et la FIG. 3B qui représente un second réseau de neurones NN2B pour le second système de contrôle;

la FIG.4A qui représente une courbe de la tension de décharge d'une batterie en fonction du temps;

la FIG.4B qui représente une courbe du temps de décharge d'une batterie en fonction de la tension de décharge;

la FIG.4C qui représente une courbe de temps de décharge moyen d'une batterie en fonction du nombre de cycles de charge-décharge;

la FIG.4D qui représente des courbes de temps de décharge d'une batterie en fonction de la tension et en fonction de là température;

la FIG.5A qui représente les éléments pour mettre en oeuvre un système de contrôle ; et la FIG.5B qui représente un système de contrôle dans un système hôte ;

la FIG.6A qui représente la structure d'une cellule neuronale de la couche cachée du premier réseau de neurones NN1A du premier système de contrôle, la FIG.GB qui représente la structure de la cellule neuronale de sortie de ce même réseau NN1A.

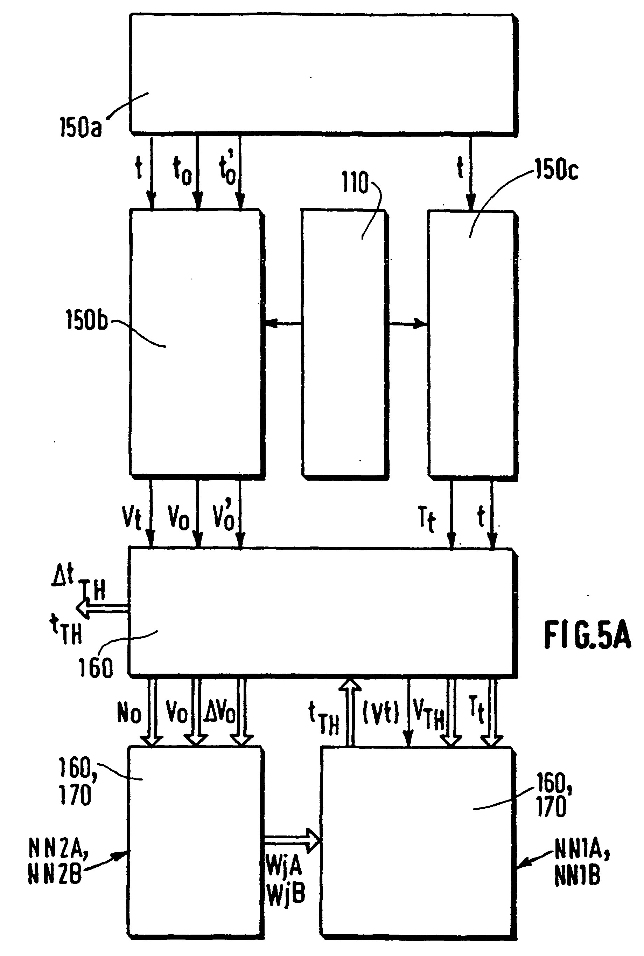

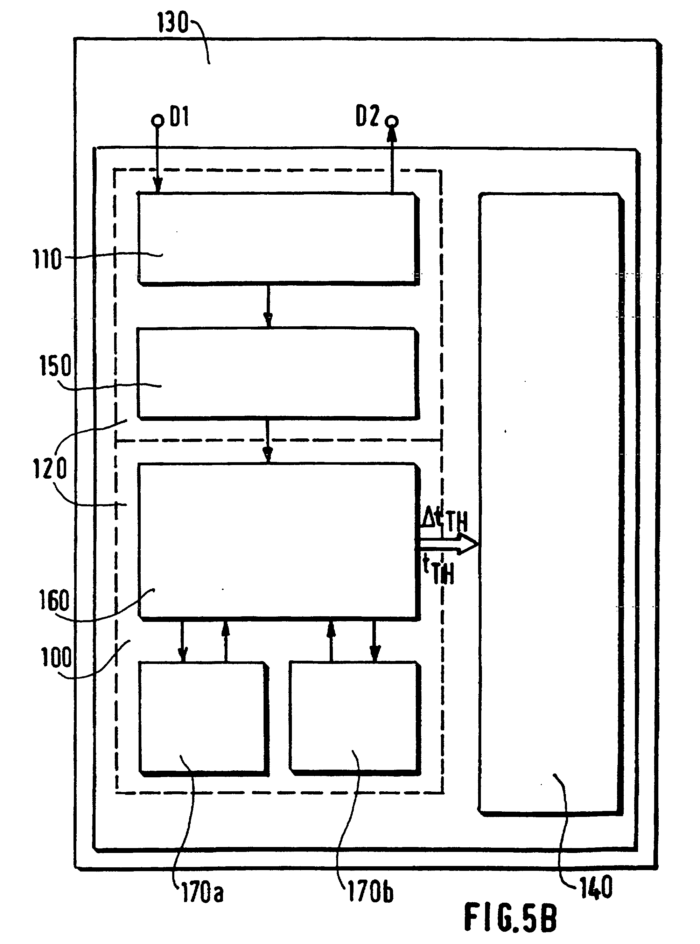

En référence avec la FIG.5B dont la légende est au Tableau II, un système de contrôle 100 est couplé à une batterie rechargeable 110, pour constituer un système global appelé batterie intelligente 120. Cette batterie rechargeable a des phases de charge alternant avec des phases de décharge selon des cycles de charge-décharge. Cette batterie intelligente 120 est couplée à, ou bien est incorporée dans un dispositif hôte 130 qui comprend des moyens 140 pour donner à l'utilisateur une indication d'un instant $t_{TH}$ ou, dans une phase de décharge, la tension de la batterie atteindra un seuil critique prédéterminé de tension $V_{TH}$, et plus spécifiquement, une indication du laps de temps $\Delta t_{TH}$ restant à courir, avant qu'un seuil critique prédéterminé de tension de décharge VT, ne soit atteint, ou bien les deux indications.

En référence avec la FIG.5A dont la légende est au Tableau I, le système de contrôle 100 est couple à des moyens de mesure du temps 150a, de mesure de la tension 150b de batterie, et éventuellement de mesure de là température 150c et à des moyens 160 effectuant l'incrémentation du nombre de cycles de charge-décharge subit par la batterie disposes dans le dispositif hôte 130.

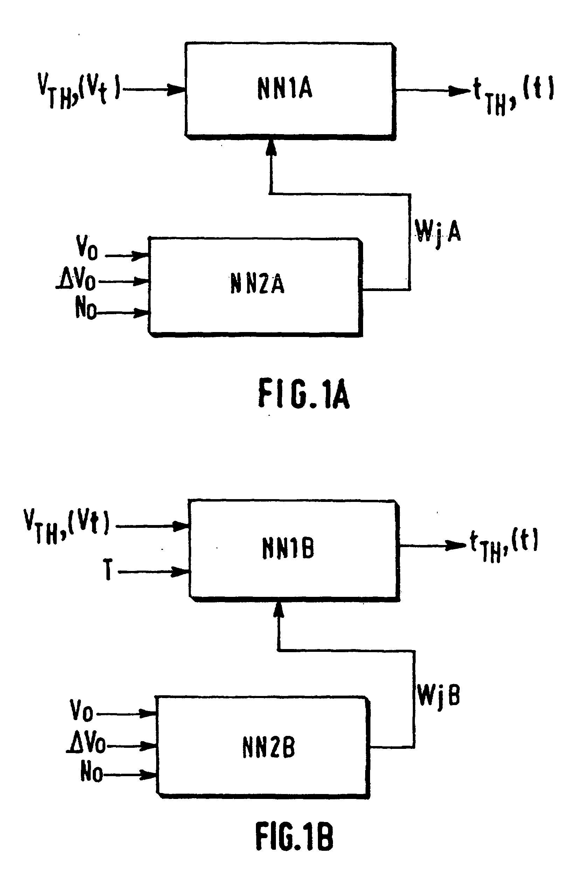

En référence avec les FIG.1A et 1B, le système de contrôle 100 collecte d'une part des valeurs appelées initiales, à un instant appelé instant initial to, qui coïncide avec le tout début d'une phase de décharge de la batterie dans un cycle de charge-décharge. Ces valeurs initiales sont :

Vo la tension de la batterie, Vo étant alors appelée tension initiale de la batterie à cet instant initial to ;

ΔVo la variation de la tension de batterie encore appelée variation de tension initiale, mesurée au tours d'un premier laps de temps Δto très court d'utilisation de la batterie entre l'instant initial to et un instant t'o = to+Δto ultérieur au tout début de la phase de décharge concernée ;

No le nombre de cycles de charges-décharges de la batterie déjà effectué avant l'instant initial considéré to; No peut éventuellement être égal a 0 ( zéro ) si le cycle considéré est le premier cycle d'utilisation de la batterie, antérieurement neuve et n'ayant jamais été rechargée.

Ce système 100 peut collecter d'autre part des valeurs instantanées à chaque instant courant ultérieur t de cette phase de décharge. Ces valeurs instantanées sont :

Vt la tension de la batterie à cet instant courant t. Eventuellement, le système 100 peut collecter d'autre part, à chaque instant t des valeurs instantanées qui sont:
Tt la température de la batterie.

En référence avec les FIGS.1A et 1B, des exemples de réalisation d'un système de contrôle 100 de Mat de charge d'une batterie rechargeable sont décrits ci-après.

Le système de contrôle 100 comprend essentiellement des premier et second moyens de calcul prédictifs et adaptatifs couples, NN1A et NN2A, ou NN1B et NN2B, pour fournir, à partir des valeur initiales de tension Vo, ΔVo, No, et d'un seuil critique $V_{TH}$, et éventuellement à partir de la valeur instantanée Tt mesurées dans une phase de décharge, l'indication prédictive d'un instant appelé instant critique $t_{TH}$ ou, dans la même phase de décharge, la tension de batterie atteindra ce seuil critique $V_{TH}$, et plus spécifiquement, une indication prédictive du laps de temps $\Delta t_{TH}$ restant à courir avant que ce seuil critique de tension de décharge $V_{TH}$ ne soit atteint, ce seuil étant prédéterminé pour que, avant que la tension de batterie n'atteigne ce seuil $V_{TH}$, le système hôte 130 dispose d'une énergie de fonctionnement précisément connue, et située dans une certaine fourchette où cette énergie est correctement adaptée au fonctionnement du dispositif hôte 130.

Exemple I

Tel que représenté sur la FIG.1A, dans un premier mode de réalisation, les premier et second moyens de calcul prédictifs et adaptatifs du système de contrôle 100 sont respectivement constitués par un premier réseau de neurones référencé NN1A, et un second réseau de neurones référencé NN2A monté en série avec le premier réseau de neurones NN1A.

Dans la description ci-après, une phase de décharge, commençant à un instant to dans un cycle de charge-décharge, est d'abord considérée ; et un seuil critique prédéterminé de tension de décharge $V_{TH}$ est fixé.

Le premier réseau de neurones NN1A a une entrée pour :

la tension $V_{TH}$ qui constitue le seuil critique prédéterminé, et a une sortie pour fournir à chaque instant courant t, par exemple toutes les minutes :
l'instant $t_{TH}$ où ce seuil critique prédéterminé de tension $V_{TH}$ est atteint.

En référence avec la FIG.5A dont la légende est au Tableau I, le premier réseau de neurones NN1A est couplé avec des moyens de mesure du temps 150a, qui fournit une mesure de chaque instant courant t, et est couplé avec des moyens de calcul 160 qui fournit par différence entre l'instant courant t et la valeur calculée de l'instant $t_{TH}$ :

une valeur $\Delta t_{TH}$ du laps de temps restant à courir avant que le seuil critique prédéterminé de tension de décharge $V_{TH}$ ne soit atteint, dans le cas où l'hôte 130 est en fonctionnement normal, et où la batterie 110 se décharge normalement du fait de ce fonctionnement.

Les coefficients synaptiques ou poids de ce premier réseau de neurones NN1A sont au nombre de 13 et sont référencée WjA où "j" est un indice de 1 à 13. Ils sont calculés et fournis automatiquement à chaque instant courant t de cette phase de décharge, par le second réseau de neurones NN2A.
Le second réseau de neurones NN2A a 3 entrées pour :

Vo la tension initiale mesurée à l'instant initial to de la phase de décharge,
ΔVo la variation initiale, à un instant to' repéré après un court laps de temps Δto, en partant de l'instant initial to, par exemple 1 minute,
No le nombre initial de cycles.

et a 13 sorties pour 13 poids WjA transmis automatiquement, à chaque instant courant t, au premier réseau de neurones NN1A.

Chacun des réseaux de neurones NN1A et NN2A doivent être organisés (ou arrangés) pour mener à bien ces calculs et fournir ces sorties. A cet effet, chacun d'eux est soumis à une procédure d'apprentissage et à une procédure de test appelées phases d'entraînement pendant lesquelles leurs coefficients synaptiques sont déterminés et, dans certains cas, fixés.

### Procédure d'apprentissage des réseaux de neurones

La tâche du premier réseau de neurones NN1A est d'apprendre des modèles de courbes de décharge. Cet apprentissage permet de construire une relation entre la tension de décharge de batterie notée Vt, et l'instant courant t où la batterie atteint cette tension Vt. Le premier réseau de neurones NN1A doit, lors de son apprentissage, construire des fonctions Fw qui résolvent la relation (1a) :

$$t = Fw(Vt) \tag{1a}$$

où l'indice w affecté à F symbolise le fait que la fonction F est liée aux poids WjA, ou coefficients synaptiques, du premier réseau de neurones NN1A.

Le réseau de neurones NN1A a été construit pour générer une fonction Fw non linéaire.

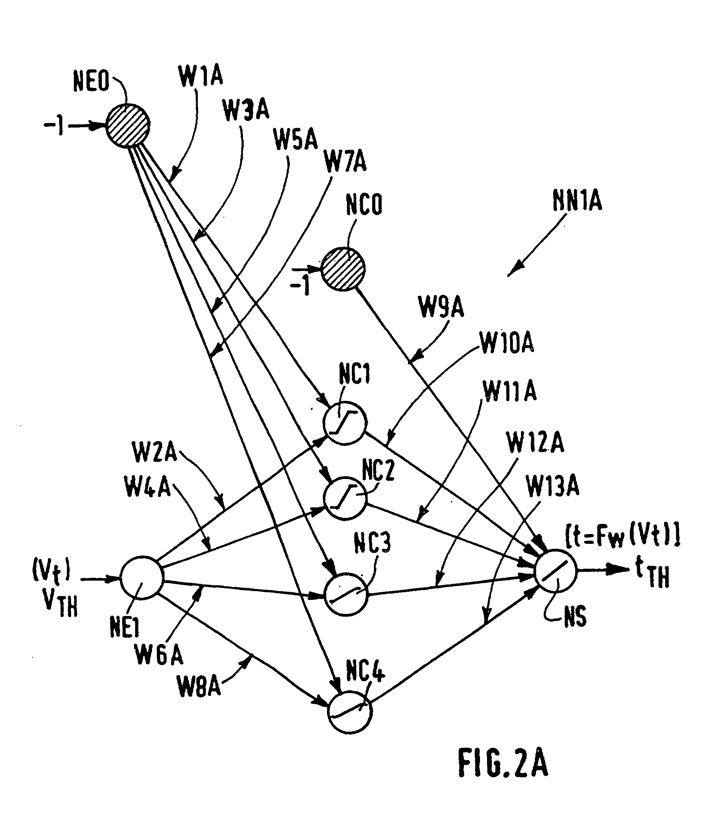

En référence avec la FIG.2A, le premier réseau de neurones NN1A comprend :

une couche d'entrée formée de 2 cellules neuronales, incluant une première cellule neuronale NE0 pour l'entrée d'une valeur de seuil choisie à -1, et une seconde cellule neuronale NE1 pour l'entrée de la valeur de tension Vt à l'instant t,

une couche cachée de 5 cellules neuronales, incluant une première cellule neuronale cachée NC0 pour l'entrée d'une valeur de seuil choisie à -1, et quatre cellules neuronales cachées notées NC1 à NC4.

et une couche de sortie ayant une cellule neuronale unique notée NS.

Donc, on remarque que, durant la procédure d'apprentissage du premier réseau de neurones NN1A, son entrée NE1 collecte une valeur de tension instantanée Vt, alors que cette même entrée collecte la valeur de seuil critique de tension $V_{TH}$ lors de l'usage courant.

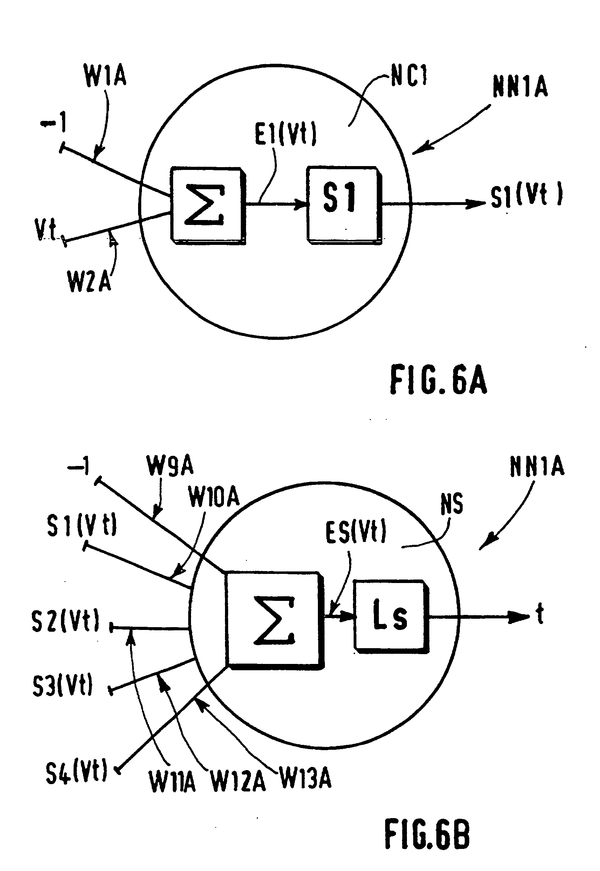

La structure et l'équation de fonctionnement de chaque neurone caché, noté NC1 à NC4, sont celles d'un neurone formel "standard", et sont illustrées par la FIG.6A, qui montre la cellule cachée NC1, à titre d'exemple.

Chaque neurone caché donné NCi reçoit d'une part en entrée la tension Vt avec un poids, ou coefficient synaptique d'entrée, qui est l'un des 13 poids référencé WjA, et reçoit d'autre part un seuil ayant pour valeur la constante "-1", affecté d'un autre des 13 poids référencé WjA. L'indice "i" est l'indice 1 à 4 de la cellule neuronale cachée NC1 à NC4 concernée. Chaque neurone caché NCi réalise une somme pondérée, notée Σ des entrées affectées d'un des poids WjA, et calcule une sortie intermédiaire Ei(Vt).

Chaque neurone caché NC1 à NC4 transfère cette sortie intermédiaire Ei(Vt), à travers une fonction d'activation notée Si, et il calcule une sortie notée Si (Vt) selon la relation (2a) :

$$Si(Vt) = Si[Ei(Vt)] \tag{2a}$$

Il reste alors à mieux définir la fonction d'activation Si(Vt) de chaque neurone caché. On peut adopter comme fonction d'activation possible, une fonction choisie dans l'ensemble des fonctions non linéaires.

La fonction d'activation Si est de préférence une fonction sigmoïde "tanh" égale à la fonction tangente hyperbolique, qui est très bien adaptée à la forme des courbes de décharge à construire, comme on le montrera ultérieurement. Dans la couche cachée, les 4 cellules neuronales NC1 à NC4 montrent donc dans l'exemple décrit, une fonction non linéaire tanh.

La structure de l'unique neurone de sortie NS est illustrée par la FIG.6B. Il réalise une somme pondérée, notée Σ, des sorties Si(Vt) de tous les neurones cachés NCi, en utilisant des coefficients synaptiques WjA, somme à laquelle s'ajoute la valeur d'un seuil "-1" provenant de la cellule cachée NC0, cette valeur de seuil étant introduite dans le neurone de sortie NS à travers l'un des coefficients synaptiques WjA.

Ce neurone de sortie effectue donc d'abord la somme pondérée Σ qui donne une sortie intermédiaire Es(Vt).

Puis, le neurone de sortie NS transfère cette sortie intermédiaire Es(Vt), à travers une fonction d'activation notée Ls, et il calcule une sortie finale notée Fw(Vt) selon la relation (3a) :

$$Fw(Vt) = Ls[Es(Vt)] \tag{3a}$$

La fonction d'activation Ls de ce neurone de sortie est choisie linéaire. La sortie du neurone de sortie est la fonction Fw que l'on cherche à générer.

Les notations des poids de chaque neurone caché NCi sont indiqués sur la FIG.2A, ainsi que les notations des poids d'entrée du neurone de sortie NS. L'ensemble de ces poids notés W1A à W13A est formé par l'ensemble des 13 poids WjA transmis par le second réseau de neurones NN2A.

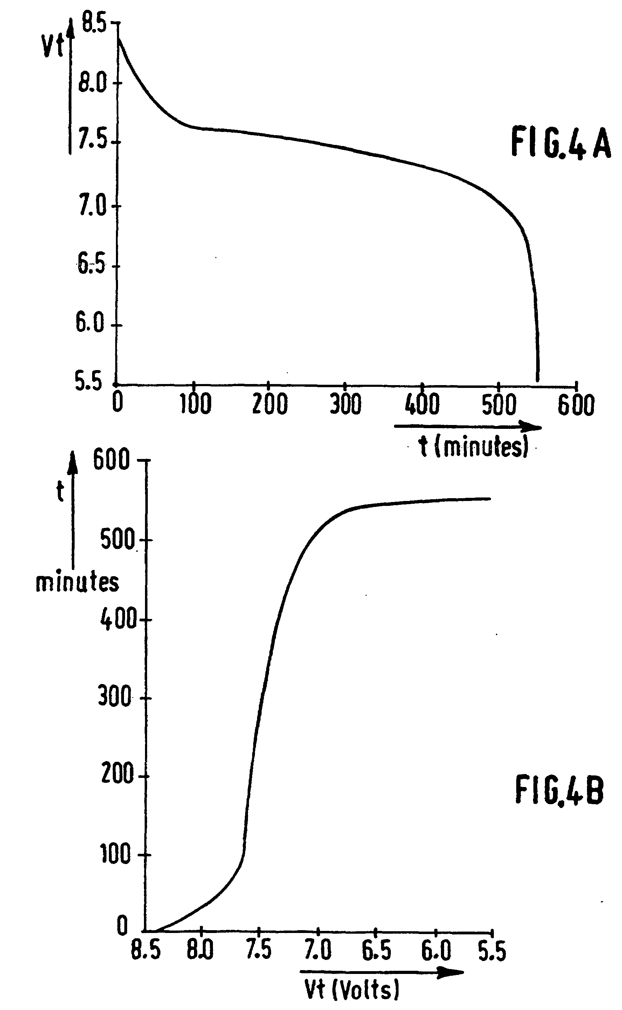

En référence avec la FIG.4A, une courbe conventionnelle de décharge d'une batterie cadmium-nickel prise à titre d'exemple, donne la tension Vt en volt en fonction du temps t en minutes. Cette courbe montre une forte pente dans la première période de fonctionnement de la batterie, par exemple les 100 premières minutes, puis une pente faible entre 100 et 500 minutes d'utilisation, et enfin à nouveau une forte pente au-delà de 500 minutes. Bien entendu, cette courbe de décharge est donnée tout à fait à titre d'exemple.

Mais, dans le présent système, on rappelle que le premier réseau de neurones NN1A doit subir un apprentissage conduisant à fournir un temps t qui est une fonction Fw de la tension Vt de la batterie.

C'est pourquoi, un exemple de courbe de décharge qui intéresse la présente description est représenté sur la FIG.4B. Cette courbe montre le temps t en fonction de la tension de batterie Vt. Cette courbe de la FIG.4B est tracée simplement en portant les valeurs qui étaient en abscisse sur la FIG.4A, en ordonnée sur la FIG.4B ; et en portant les valeurs qui étaient en ordonnée sur la FIG.4A en abscisse sur la FIG.4B . On peut constater que cette courbe de décharge a une forme approchant la forme d'une courbe tanh. C'est pourquoi, les fonctions du type des sigmoïdes sont préférées pour réaliser les fonctions d'activation dans les neurones de la couche cachée.

La FIG.4B fournit maintenant une courbe de décharge donnant le temps t en minutes en fonction de la tension Vt en volt qui montre des parties extrêmes quasiment planes et une partie intermédiaire ayant une pente abrupte. C'est pourquoi la modélisation de la partie intermédiaire des courbes de décharge de la relation (1a) est effectuée par les deux premières cellules neuronales NC1, NC2 de la couche cachée, dont les fonctions d'activation ont respectivement une pente forte ; alors que la modélisation des parties extrêmes de ces courbes est effectuée par les cellules neuronales cachées suivantes NC3, NC4, qui montrent une fonction d'activation à pente moins forte.

La présence de cellules cachées ayant des fonctions d'activation montrant des pentes très nettement différentes revient à spécialiser chaque cellule cachée dans la réalisation de taches différentes prédéterminées. Il est clair que le réseau de neurones NN1A pourrait apprendre la tâche de fournir la fonction Fw avec le même niveau de performance, sans que cette spécialisation existe. Mais, selon l'invention, il a été trouvé que la phase d'apprentissage du réseau de neurones NN1A se trouve considérablement raccourcie du fait que chaque cellule est dédiée à une tâche prédéterminée.

Les pentes des fonctions d'activation Si des cellules cachées NC1, NC2 peuvent être par exemple 7.0, et les pentes de fonctions d'activation des cellules cachées suivantes NC2, NC4 peuvent être par exemple 2.0.

Pour l'apprentissage du premier réseau de neurones NN1A, des courbes de temps t de décharge en fonction de la tension V(t) de décharge sont enregistrées par exemple toutes les minutes pour un grand nombre N de cycles de décharge, et pour un grand nombre de batteries 110 du même type, par exemple des batteries cadmium-nickel.

Dans un exemple, 20 batteries sont utilisées, et subissent 140 cycles de charge-décharge. Une période de charge dure 16 heures. Une batterie est considérée comme totalement chargée quand sa tension Vo est de 9V, et est considérée comme ayant atteint le seuil critique de décharge quand sa tension atteint $V_{TH} =$ 6V. Par cette méthode, 20 x 140 = 2800 courbes de décharge sont enregistrées, de telle manière que chaque courbe fournit 1600 points.

Chaque courbe est enseignée à un réseau NN1A différent. Ainsi dans la phase d'apprentissage, 2800 réseaux sont initialisés, c'est-à-dire 1 réseau par courbe. Dans chaque courbe, par exemple la moitié des points, c'est-à-dire 800 points, est utilisée pour l'apprentissage du réseau de neurone correspondant et, l'autre moitié des points, c'est-à-dire 800 autres points, est utilisée pour tester ledit réseau de neurones.

A l'issue de cet entraînement comprenant la phase d'apprentissage et les tests, les 13 poids WjA de chacun des 2800 réseaux de neurones NN1A sont mémorisés dans une zone de mémoire vive RAM.

En référence avec la FIG.5B, la mémoire vive est référencée 170b.

A partir de là, les valeurs des lots de 13 poids WjA en mémoire vont constituer une base de données pour l'apprentissage du second réseau de neurones NN2A.

La tâche du second réseau de neurones NN2A est d'apprendre une relation entre des paramètres dépendant de la tension de décharge de la batterie. Ainsi, le second réseau de neurones NN2A reçoit

No le nombre de cycles antérieurs,

Vo la première tension enregistrée d'une courbe de décharge donnée,

et ΔVo la pente à l'origine de cette courbe de décharge, et doit pouvoir calculer, à partir de ces mesures, les 13 poids WjA nécessaires au fonctionnement du premier réseau de neurones NN1B. Cette relation s'exprime par la fonction G de la relation (4a) :

$$WjA = G(Vo, \Delta Vo, No) \qquad (4a)$$

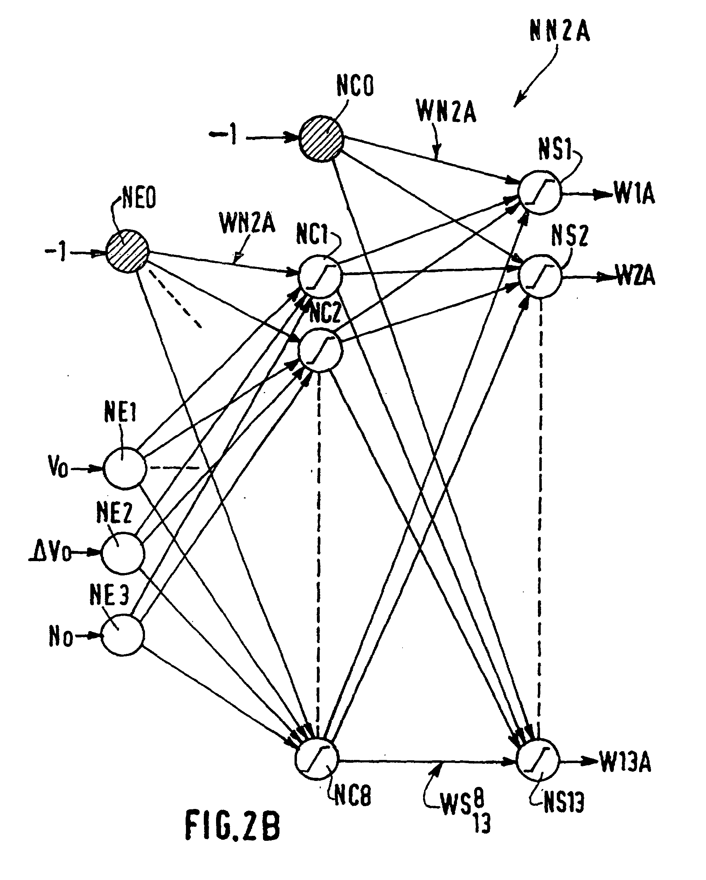

En référence avec la FIG.2B, la structure du second réseau de neurones NN2A est dictée par sa tâche. Ce réseau NN2A comprend :

une couche d'entrée avec 3 cellules d'entrée NE1, NE2, NE3 pour les valeurs Vo, $\Delta Vo$ et No, plus une cellule d'entrée NE0 pour un seuil à -1 ;
13 cellules de sortie NS1 à NS13 pour respectivement chacun des 13 poids WjB à calculer ;
une seule couche cachée avec 8 cellules neuronales cachées notées NC1 à NC8, plus une cellule cachée NC0 pour un seuil à -1.

Selon l'invention, les entrées constituées par les valeurs initiales Vo et $\Delta Vo$ ont été spécifiquement choisies parce qu'il est apparu que c'était les valeurs les plus sensibles aux caractéristiques de la batterie.

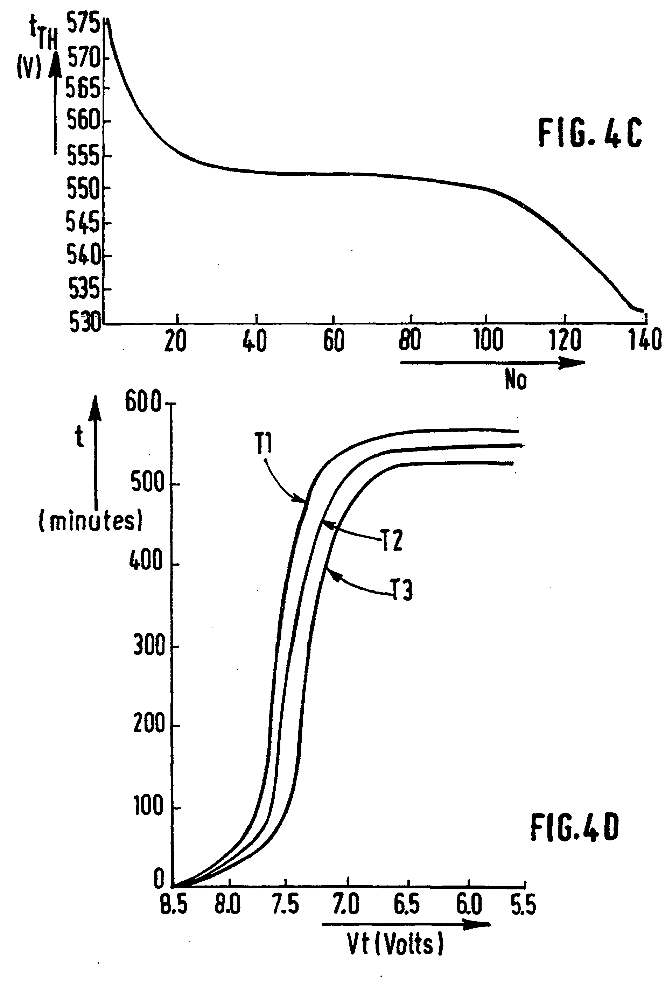

La troisième entrée constituée par le nombre initial de cycle No a été également spécifiquement choisie parce qu'elle permet de prendre en compte un effet de vieillissement de la batterie, du fait que plus une batterie a subi de cycles de charge-décharge, moins il lui reste de temps de vie, c'est-à-dire moins l'effet de la recharge est efficace et plus le temps de décharge est rapide. Cet effet de vieillissement est illustré par la FIG.4C, qui montre le temps de décharge moyen $t_{TH}$ pour atteindre le seuil critique $V_{TH}$ à partir de l'instant initial to, en fonction du nombre initial de cycles No.

**[0070]** Les coefficients synaptiques ou poids, référencés WN2A de ce second réseau de neurones sont fixés lors de sa phase d'apprentissage et sont mis en mémoire dans la zone de mémoire morte ROM 170a, représentée sur la FIG.5B.

Des essais appliqués au réseau de neurones NN2A ont montré qu'un tel réseau muni de 8 cellules cachées, ayant pour fonction d'activation une fonction non linéaire tangente hyperbolique tanh est capable de mener à bien la tache qui lui est assignée.

Il faut noter que, à la différence de la cellule de sortie NS du premier réseau de neurone, les cellules de sortie, notées NS1 à NS13 du second réseau de neurone NN2A ont une fonction d'activation non linéaire, de préférence tanh.

Comme le premier réseau de neurones NN1A, ce second réseau de neurones NN2A a des cellules cachées dont la pente de la fonction d'activation sigmoïde est différente d'une cellule à l'autre. Ce mode de réalisation permet de ne pas utiliser un nombre important de cellules cachées.

Ainsi, le second réseau de neurones est entraîné en utilisant 1400 vecteurs de 13 valeurs de poids générés par l'apprentissage du premier réseau de neurone au moyen des 2800 courbes enregistrées, et les 1400 autres vecteurs générés sont utilisés pour les tests.

La procédure de test est réalisée de la manière suivante : pour les 1400 vecteurs qui n'appartiennent pas au lot d'apprentissage, les valeurs correspondantes Vo, $\Delta Vo$ et No sont appliquées aux entrées du second réseau de neurones. Celui-ci calcule un vecteur de sortie de 13 valeurs de poids comme il a été entraîné à le faire.

Poursuivant cette procédure de test, ces 13 valeurs de poids sont imposées à un réseau de neurone NN1A, en même temps que la valeur critique prédéterminée de tension de décharge $V_{TH}$ = 6 volts est appliquée à son entrée EC1. Ce premier réseau de neurone NN1A calcule alors la valeur prédictive automatiquement adaptée de temps de décharge $t_{TH}$ qui est comparée à celle de la courbe de test.

**Modes opératoires du système de contrôle de batterie rechargeable**

Le système de contrôle 100 a deux modes opératoires appelés mode d'initialisation et mode d'usage courant.

**Le mode d'initialisation** est mis en oeuvre chaque fois que la batterie 110 a terminé une procédure de charge ou de recharge, et qu'elle commence alors à être déchargée. Dès que la batterie 110 est mise en service, la tension initiale Vo est aussitôt enregistrée. Puis, à l'instant t'o, après qu'un très petit laps de temps to - t'o = $\Delta$to s'est écoulé, de préférence exactement 1 minute, la tension de batterie est à nouveau enregistrée donnant une valeur notée V'o, et la différence de tension initiale Vo - V'o = $\Delta Vo$ est calculée, par exemple par des moyens de calcul 160 montrés sur les FIG.5A et 5B. Ensuite, les deux valeurs Vo et $\Delta Vo$, en même temps que le nombre initial No des cycles déjà effectués, nombre qui est calculé par incrémentation par les moyens de calcul 160, sont fournis à l'entrée du second réseau de neurones NN2A qui calcule alors le vecteur de 13 valeurs de poids WjA à appliquer au premier réseau de neurones NN1A.

**Le mode d'usage** courant est mis en oeuvre pendant la décharge. Dans ce mode d'usage courant, la tension Vt n'a pas besoin d'être mesurée. L'entrée NC1 du premier réseau de neurone NN1A reçoit la tension $V_{TH}$ = 6. Le laps de temps restant $\Delta t_{TH}$ avant que la batterie n'atteigne ce seuil critique prédéterminé est alors calculé comme une différence entre un temps $t_{TH}$ et un temps t,

où $t_{TH}$ est la sortie du réseau NN1A quand son entrée est mise à $V_{TH}$ = 6 V,

et où t est une mesure de temps fournie par des moyens de mesure 150a montrés sur la FIG.5A.

Ce calcul de différence de temps, peut être effectué par le premier réseau de neurones NN1A, ou bien il peut être effectué par une zone de calcul individuelle, ou bien il peut être effectué par les moyens de calcul 160 constitués de préférence par un microprocesseur montré sur les FIG.5A et 5B.

**Exemple II**

Tel que représenté sur la FIG.1B, dans un second mode de réalisation, le système de contrôle 100 comporte un premier réseau de neurones référencé NN1B, et un second réseau de neurones référencé NN2B monté en série avec le premier réseau de neurones NN1B.

Dans la description ci-après, une phase de décharge, commençant à un instant to, dans un cycle de charge-décharge, est d'abord considérée ; et un seuil critique prédéterminé de tension de décharge $V_{TH}$ est fixé.

Le premier réseau de neurones NN1B a maintenant deux entrées pour, respectivement :

le seuil critique prédéterminé de tension $V_{TH}$,
la température Tt de la batterie à cet instant courant t, et a une sortie pour fournir à chaque instant courant t, par exemple toutes les minutes :
l'instant $t_{TH}$ où ce seuil critique prédéterminé de tension $V_{TH}$ est atteint.

En référence avec la FIG.5A, le premier réseau de neurones NN1A est couplé avec des moyens de mesure du temps 150a, qui fournit une mesure de chaque instant courant t, et est couplé avec des moyens de calcul 160 qui fournit par différence entre l'instant courant t et la valeur calculée de l'instant $t_{TH}$ ;
une valeur $\Delta t_{TH}$ du laps de temps restant à courir avant que le seuil critique prédéterminé de tension de décharge $V_{TH}$ ne soit atteint, en fonctionnement normal.

Les coefficients synaptiques ou poids, référencés WjB, de ce premier réseau de neurones NN1B sont calculés et fournis à l'instant courant t de cette phase de décharge, comme dans le premier mode de réalisation déjà décrit, par le second réseau de neurones NN2B.

Le second réseau de neurones NN2B a 3 entrées pour :

Vo la tension initiale mesurée à l'instant initial to de la phase de décharge,
$\Delta$Vo la variation initiale dans un court laps de temps $\Delta$to, par exemple 1 minute,
No le nombre de cycles initial.

et a maintenant 17 sorties pour 17 poids WjB transmis au premier réseau de neurones NN1B.

Chacun des réseaux de neurones NN1B et NN2B doivent être organisés (ou arrangés) pour mener à bien ces calculs et fournir ces sorties. A cet effet, chacun d'eux est soumis à une procédure d'apprentissage et à une procédure de test appelées phases d'entraînement pendant lesquelles leurs coefficients synaptiques sont déterminés et, dans certains cas, fixés.

**Procédure d'apprentissage des réseaux de neurones**

La tâche du premier réseau de neurones NN1B est d'apprendre des modèles de courbes de décharge. Cet apprentissage permet de construire une relation entre la tension de batterie Vt, la température Tt, et l'instant t où la batterie atteint cette tension de décharge notée Vt, pour cette température Tt. Le premier réseau de neurones NN1B doit, lors de son apprentissage, construire des fonctions Fw qui résolvent la relation (1b) :

$$t = Fw(Vt,Tt) \qquad\qquad (1b)$$

où le signe w affecté à F symbolise le fait que la fonction F est liée aux coefficients synaptiques, au poids WjB du premier réseau de neurones NN1B.

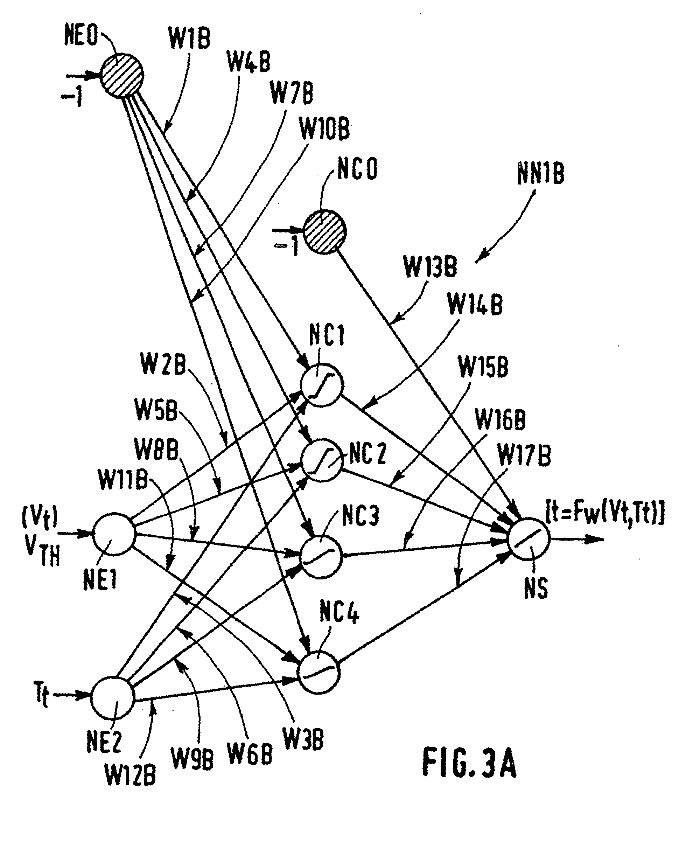

En référence avec la FIG.3A, le premier réseau de neurones NN1B du système de contrôle 100 comprend :

une couche d'entrée formée de 3 cellules neuronales, incluant une première cellule neuronale NE0 pour l'entrée d'une valeur de seuil fixée à -1, une seconde cellule neuronale NE1 pour l'entrée de la valeur de tension Vt à l'instant t, et une troisième cellule neuronale NE2 pour l'entrée de la valeur de la température Tt à ce même instant t, une couche cachée de 5 cellules neuronales, incluant une première cellule neuronale cachée NC0 pour l'entrée d'une valeur de seuil fixée à -1, et quatre cellules neuronales cachées notées NC1 à NC4, comme cela était le cas dans le premier système de contrôle 100,

et une couche de sortie ayant une cellule neuronale unique notée NS.

Les phases d'apprentissage et de test de chacun des deux réseaux de neurones NN1B et NN2B sont mises en oeuvre de la même manière que les phases d'apprentissage et de test des réseaux de neurones NN1A et NN2A du premier exemple de réalisation du système de contrôle, à ceci près que les courbes de décharge sont apprises pour plusieurs températures différentes.

Les poids de ce premier réseau de neurones sont référencés WjB et sont au nombre de 17. L'indice "j" représente les nombres 1 à 17.

Chaque neurone caché donné NCi reçoit d'une part en entrée la tension Vt avec un des poids référencés WjB, la température avec un autre des poids WjB, et reçoit d'autre part un seuil ayant pour valeur la constante "-1", affecté d'un autre des poids WjB. L'indice "i" est l'indice 1 à 4 de la cellule neuronale cachée NC1 à NC4 concernée. Chaque neurone caché NCi réalise une somme pondérée, et calcule une sortie intermédiaire comme décrit en relation avec le premier mode de réalisation du système de contrôle 100.

Chaque neurone caché NC1 à NC4 transfère cette somme pondérée, à travers une fonction d'activation Si, et il calcule une sortie notée Si(Vt,Tt) comme déjà décrit, tenant compte maintenant de la température.

La fonction d'activation Si est encore, dans ce deuxième exemple, une fonction sigmoïde "tanh" représentant la fonction tangente hyperbolique, qui est très bien adaptée à la forme des courbes de décharge à construire. Donc, dans la couche cachée, les 4 cellules neuronales CN1 à CN4 montrent une fonction non linéaire tanh.

La structure de l'unique neurone de sortie NS réalise une somme pondérée des sorties Si(Vt,Tt) de tous les neurones cachés NCi, en utilisant des coefficients synaptiques WjB, somme à laquelle s'ajoute la valeur d'un seuil "-1" provenant de la cellule cachée NC0, cette valeur de seuil étant introduite dans le neurone de sortie NS à travers l'un des coefficients synaptiques WjB.

Le neurone de sortie NS transfère cette somme pondérée à travers une fonction d'activation notée Ls, et il calcule une sortie notée Fw(Vt,Tt). La fonction d'activation Ls de ce neurone de sortie est linéaire. La sortie du neurone de sortie NS est donc la valeur Fw que l'on cherche à générer.

Les notations des poids de chaque neurone caché NCi sont indiquées sur la figure 3A, ainsi que les notations des poids d'entrée du neurone de sortie NS. L'ensemble de ces poids notés W1B à W17B est formé par l'ensemble des 17 poids WjB transmis par le second réseau de neurones NN2B.

Un exemple de courbes de décharge qui intéresse la présente description est représenté sur la FIG.4D. Cette courbe montre le temps t en fonction de la tension de batterie Vt, pour différentes valeurs T1, T2, T3, de la température T considérée comme un paramètre. Ces courbes de décharge ont chacune une forme approchant la forme d'une courbe tanh. C'est pourquoi, les fonctions du type des sigmoïdes sont préférées pour réaliser les fonctions d'activation dans les neurones de la couche cachée.

Comme dans l'exemple I, la modélisation de la partie intermédiaire des courbes de décharge est effectuée par les deux premières cellules neuronales de la couche cachée NC1, NC2, dont les fonctions d'activation ont respectivement une pente forte, alors que la modélisation des parties extrêmes de ces courbes est effectuée par les cellules neuronales cachées suivantes NC3, NC4, qui montrent une fonction d'activation à pente moins forte.

Dans cet exemple II, en référence avec la 3B, la tâche du second réseau de neurones NN2B est d'apprendre une relation entre des paramètres dépendant de la tension de décharge de la batterie. Ainsi, le second réseau de neurones NN2B reçoit No le nombre de cycles antérieurs appelé nombre initial de cycles de charge-, décharge, Vo la première tension enregistrée d'une courbe de décharge donnée, et $\Delta$Vo la pente à l'origine de cette courbe de décharge, et doit pouvoir calculer, à partir de ces mesures, les 17 poids WjB nécessaires au fonctionnement du premier réseau de neurones NN1B. Cette relation s'exprime par la fonction (4b) :

$$WjB = G(Vo, \Delta Vo, No) \qquad\qquad (4b)$$

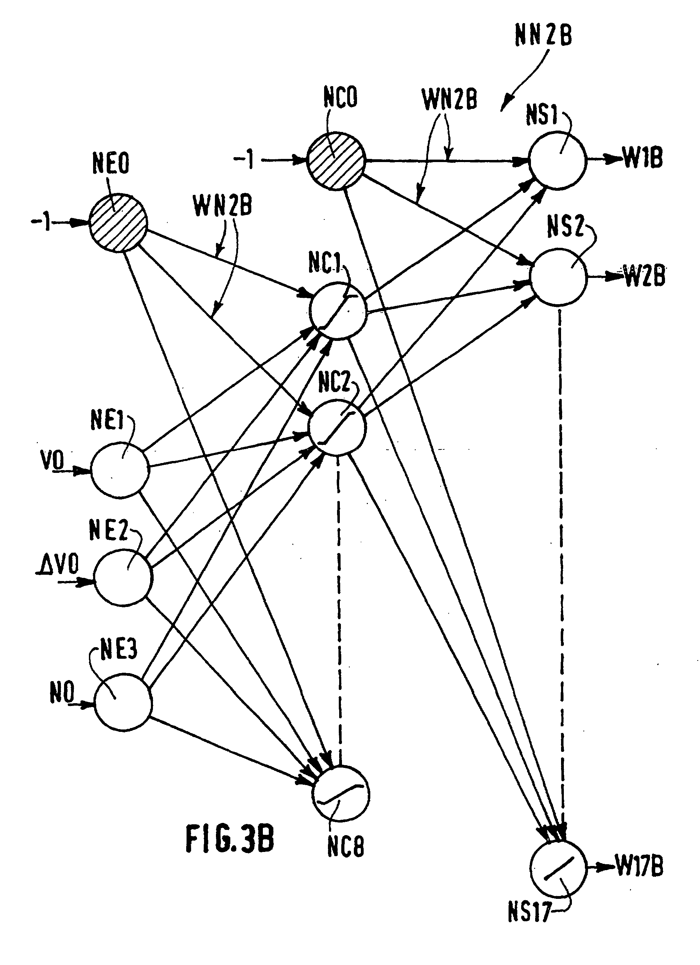

En référence avec la FIG.3B, la structure du second réseau de neurones NN2B est dictée par sa tâche. Ce réseau NN2B comprend :

une couche d'entrée avec 3 cellules d'entrée NE1, NE2, NE3 pour les valeurs Vo, $\Delta$Vo et No, plus une cellule d'entrée NE0 pour un seuil à -1 ;

17 cellules de sortie pour respectivement chacun des 17 poids WjB à calculer ;

une seule couche cachée avec 8 cellules neuronales cachées notées NC1 à NC8, plus une cellule cachée NC0 pour un seuil à -1

Dans cet exemple II, l'entraitement des réseaux de neurones et leur mode opératoire initialisation et usage courant est le même que dans l'exemple I en tenant compte de l'entrée Tt du premier réseau de neurones NN1B.

## Exemple III

Dans un exemple de réalisation du système de contrôle de l'état de charge d'une batterie, le premier réseau de neurones peut donner en sortie, d'une manière indépendante, soit une indication de l'instant $t_{TH}$ où la valeur critique $V_{TH}$ du seuil de tension est atteinte, soit une indication, soit les deux indications.

En effet, l'indication de l'instant $t_{TH}$ est obligatoirement calculée dans le mode appelé mode d'usage courant, lorsque l'entrée du premier réseau de neurones NN1A ou NN1B est mise à la valeur de seuil $V_{TH}$ = 6V, pour pouvoir calculer le laps de temps $\Delta t_{TH}$ par différence entre l'instant t et l'instant $t_{TH}$. Cette différence peut être calculée en dehors du premier réseau de neurones par les moyens de calcul notés 160 sur les FIG.5A et 5B. Cette indication de l'instant $t_{TH}$ peut alors être mise à la disposition de l'utilisateur du système hôte par des moyens d'affichage 140 appropriés donnant l'heure.

De plus, après une phase de décharge, la batterie est soumise à une phase de charge qui est achevée lorsque la tension de batterie atteint la valeur initiale Vo, qui est par exemple 9V. Dans cet exemple, les moyens d'affichage peuvent afficher une indication que la recharge de la batterie est terminée.

## Exemple IV

En référence avec la FIG.5A dont la légende est au Tableau I, le système de contrôle 100 est mis en oeuvre par un microprocesseur 160 pour réaliser les calculs, et des zones mémoire 170a, 170b pour mémoriser les données. Ces zones mémoire sont accessibles par le microprocesseur 160 et incluent une zone mémoire de stockage ROM 170a pour stocker les données de structure des premier et second réseaux de neurones NN1A, NN2A, NN1B, NN2B, les paramètres fixes et les poids WN2A, WN2B du second réseau de neurones, et une zone de mémoire vive RAM 170b pour enregistrer ou fournir selon le cas les mesures variables et les vecteurs de poids WjA, WjB du premier et du second réseaux de neurones. Le microprocesseur 160 effectue les calculs nécessaires au fonctionnement du système de contrôle.

En référence avec la FIG.5B, dont la légende est au Tableau II, le système de contrôle 100 est couplé à des moyens d'affichage 140 pour fournir à l'utilisateur une indication du temps $t_{TH}$ ou bien du laps de temps $\Delta t_{TH}$ restant à courir à partir d'un instant courant t d'utilisation jusqu'à l'instant où la batterie atteindra ce seuil de tension critique prédéterminé $Vt_{TH}$, ou bien les deux indications. Les moyens d'affichage 140 peuvent en outre afficher l'heure, c'est-à-dire une indication de l'instant courant t ; ces moyens d'affichage peuvent en outre afficher une indication, dans une phase de recharge de la batterie, que cette phase de recharge est terminée, lorsque la batterie a atteint la tension initiale Vo.

Comme cité précédemment, le système de contrôle 100 fait partie d'un dispositif hôte 130 qui comprend des moyens de connexion D1, D2 pour la batterie rechargeable 110. La batterie rechargeable 110 est couplée au système de contrôle 100 pour former la batterie intelligente 120. Le dispositif hôte 130 abrite en outre les moyens de mesure 150, par exemple un multimètre, le microprocesseur 160, les zones mémoire 170a, 170b accessibles par le microprocesseur 160, et les moyens d'affichage 140.

Pour la réalisation des moyens d'affichage, plusieurs dispositifs connus de l'état de la technique sont utilisables. Un dispositif peut être un écran avec des indications écrites, ou avec des indications dessinées, ou encore un panneau formée de diodes.

## TABLEAU I (FIG.5A)

| 150a | Moyens de mesure du temps $t_o$, $t'_o$, $t$ |
|---|---|
| 150b | Moyens de mesure des tensions $V_o$, $V'_o$, $Vt$ |
| 150c | Moyens de mesure des températures $Tt$ |
| 110 | Batterie rechargeable |
| 160 | Microprocesseur pour effectuer les calculs $\Delta t_{TH} = t - t_{TH}$ $\Delta Vo = Vo - V'o$, No |
| NN1A } NN1B | Premier réseau de neurones |
| NN2A } NN2B | Second réseau de neurones |
| 170 | Zones de mémoire |

## TABLEAU II

| (FIG.5B) | |
|---|---|
| 130 | Dispositif hôte |
| D1, D2 | Connexion du dispositif hôte et de la batterie |
| 110 | Batterie rechargeable |
| 150 | Moyens de mesure du temps, température et tensions |
| 160 | Microprocesseur pour effectuer les calculs |
| 170a | Zone de mémoire morte (ROM) |
| 170b | Zone de mémoire vive (RAM) |
| 100 | Système de contrôle de batterie |
| 120 | Batterie intelligente |
| 140 | Moyens d'affichage de l'instant courant et des temps calculés, et éventuellement de fin de charge. |

## Revendications

1. Système de contrôle de la phase de décharge des cycles de charge-décharge d'une batterie, destiné à être couplé à une batterie rechargeable ayant des phases de charge alternant avec des phases de décharge selon des cycles de charge-décharge, ce système comprenant:

des premiers moyens de calcul adaptatifs (NN1A,NN1B) arrangés pour collecter, à un instant initial (to) au commencement d'une phase de décharge d'un cycle de charge-décharge de la batterie, une valeur prédéterminée d'un seuil critique de tension de décharge ($V_{TH}$), et pour calculer et fournir une indication prédictive d'un instant critique ($t_{TH}$) où la batterie atteindra ce seuil critique prédéterminé de tension de décharge ($V_{TH}$), des seconds moyens de calcul adaptatifs (NN2A, NN2B), couplés aux premiers moyens de calcul, arrangés pour collecter, à l'instant initial (to), une mesure d'une tension initiale (Vo), d'une variation initiale ($\Delta$Vo) de la tension à un nouvel instant t'o après un court laps de temps ($\Delta$to) à partir de cet instant initial (to), et du nombre initial (No) de cycles de charges-décharges déjà effectués dans cette batterie avant cet instant initial (to), et pour calculer et fournir, dès l'instant, to + $\Delta$to, de la phase concernée où les mesures initiales sont disponibles, des paramètres de fonctionnement automatiquement adaptés aux valeurs des mesures initiales et imposés aux premiers moyens de calcul.

2. Système de contrôle selon la revendication 1, dans lequel les premiers moyens de calcul adaptatifs (NN1A, NN1B) sont aussi arrangés pour collecter, à un instant courant (t), dans la phase de décharge considérée du cycle de charge-décharge de la batterie en tours, une mesure de la température (Tt), et pour calculer et fournir, à cet instant courant (t), une indication prédictive d'un instant critique ($t_{TH}$) où la batterie atteindra le seuil critique prédéterminé de tension de décharge (VT,).

3. Système de contrôle selon l'une des revendications 1 ou 2, dans lequel :

les premiers moyens de calcul adaptatifs sont aussi arrangés pour calculer et fournir, à chaque instant courant (t), une indication prédictive du laps de temps ($\Delta t_{TH}$) restant à courir à partir de cet instant courant (t) jusqu'à l'instant critique ($t_{TH}$) où la batterie atteindra le seuil critique prédéterminé de tension de décharge ($V_{TH}$), ou une indication prédictive de cet instant critique ($t_{TH}$).

4. Système de contrôle selon la revendication 1, dans lequel les moyens de calcul adaptatifs sont constitués par :

un premier réseau de neurones (NN1A) arrangé pour calculer et fournir, à chaque instant courant (t), à partir du seuil critique prédéterminé de tension de décharge ($V_{TH}$), une indication prédictive de l'instant critique ($t_{TH}$) où la batterie atteindra ce seuil critique prédéterminé de tension de décharge ($V_{TH}$), un second réseau de neurones (NN2A) monté en série avec le premier réseau de neurones, arrangé pour calculer et fournir, à partir de la mesure des valeurs de tension initiale (Vo), de variation initiale de tension ($\Delta$Vo) et nombre initial de cycles (No), à chaque commencement de phase de décharge de chaque cycle de décharge, dès l'instant (to + $\Delta$to) de la phase concernée où les mesures initiales sont disponibles, des poids synaptiques (WjB) automatiquement adaptés imposés au premier réseau de neurones.

5. Système de contrôle selon la revendication 2, dans lequel les moyens de calcul adaptatifs sont constitués par :

un premier réseau de neurones (NN1B) arrangé pour calculer et fournir, à chaque instant courant (t), à partir du seuil critique prédéterminé de tension de décharge ($V_{TH}$), et à partir de la mesure de la température (Tt), une indication prédictive de l'instant critique ($t_{TH}$) où la batterie atteindra ce seuil critique prédéterminé de tension de décharge ($V_{TH}$), un second réseau de neurones (NN2B) monté en série avec le premier réseau de neurones, arrangé pour calculer et fournir, à partir de la mesure des valeurs de tension initiale (Vo), de variation initiale de tension ($\Delta$Vo) et nombre initial de cycles (No), à chaque commencement de phase de décharge de chaque cycle de décharge, dès l'instant, to + $\Delta$to, de la phase concernée où les mesures initiales sont disponibles, des poids synaptiques (WjB) automatiquement adaptés imposés au premier réseau de neurones.

6. Système de contrôle selon l'une des revendications 4 ou 5, dans lequel :

le premier réseau de neurones (NN1A,NN1B) est arrangé pour calculer et fournir, à chaque instant courant (t), à partir du seuil critique prédéterminé de tension de décharge (VT,), et éventuellement à partir de la mesure de la température (Tt), une indication prédictive du laps de temps ($\Delta t_{TH}$) restant à courir à partir de cet instant courant (t) jusqu'à l'instant critique ($t_{TH}$) où la batterie atteindra ce seuil critique prédéterminé de tension de décharge ($V_{TH}$).

7. Système de contrôle selon l'une des revendications 4 à 6, dans lequel le premier réseau de neurone a trois couches, dont une couche de deux ou trois cellules d'entrée pour respectivement un seuil, une valeur de tension et éventuellement une valeur de température, une couche de cellules cachées, et une cellule de sortie, les cellules de la couche cachée ayant une fonction d'activation sigmoïde de pente différente d'une cellule à l'autre, et la cellule de la couche de sortie ayant une fonction d'activation linéaire.

8. Système de contrôle selon la revendication 7, dans lequel le second réseau de neurone a trois couches de cellules neuronales, dont une couche de quatre cellules d'entrée pour respectivement un seuil, et chacune des valeurs initiales, une couche de cellules cachées, et une couche de cellules de sortie, les cellules de la couche cachée ayant une fonction d'activation sigmoïde de pente différente d'une cellule à l'autre, et les cellules de la couche de sortie étant en nombre égal au nombre des coefficients synaptiques nécessaires au fonctionnement du premier réseau de neurones et ayant une fonction d'activation sigmoïde.

9. Système de contrôle selon l'une des revendications 1 à 8, ce système (100) étant couplé à une batterie rechargeable (110), à des moyens de mesure de temps (150a), de mesure de tension (150b), éventuellement à des moyens de mesure de température (150c), et à des moyens d'affichage (140) arrangés pour fournir soit une indication de l'instant critique ($t_{TH}$) où la batterie atteindra le seuil de tension critique ($vt_{TH}$), soit une indication du laps de temps ($\Delta t_{TH}$) restant à courir à partir d'un instant courant (t) d'utilisation jusqu'à l'instant ($t_{TH}$) où la batterie atteindra un seuil de tension critique prédéterminé ($Vt_{TH}$), soit les deux indications, et éventuellement une indication de la fin de phase de recharge de batterie.

10. Système de contrôle selon la revendication 9, comprenant:

un microprocesseur (160) pour réaliser les calculs, et
des zones de mémoire (170a, 170b) pour mémoriser les données, ces zones de mémoire étant accessibles par le microprocesseur (160) et incluant une zone de mémoire de stockage (170a) pour stocker les données de structure des réseaux de neurones, les paramètres fixes et les coefficients synaptiques du second réseau de neurones, et une zone de mémoire vive (170b) pour enregistrer ou fournir les mesures variables, et les coefficients synaptiques du premier réseau de neurones.

11. Dispositif hôte (130) comprenant un système de contrôle selon l'une des reveadications 9 ou 10, ce dispositif hôte étant alimenté par la batterie rechargeable qui est couplée au dit système de contrôle.

12. Procédé d'entraînement des réseaux de neurones du système de contrôle selon l'une des revendications 7 ou 8, comprenant dans une phase d'apprentissage :

- l'apprentissage, par le premier réseau de neurones, de courbes de temps de décharge (t) en fonction de la tension de décharge (Vt) et éventuellement de la température (Tt) comme paramètre, durant lequel des tensions de décharge (Vt) sont imposées à l'entrée du premier réseau de neurones normalement destinée à la valeur de tension, et les temps correspondants a la sortie, pour former une base de données constituée de vecteurs des coefficients synaptiques (WjA, WjB) de ce premier réseau de neurones,
- l'apprentissage par le second réseau de neurones de relations entre les valeurs initiales (Vo, $\Delta$Vo, No) et les coefficients synaptiques (WjA, WjB) calcules dans son apprentissage du premier réseau de neurones, pour déterminer et fixer ses propres coefficients synaptiques.

**Patentansprüche**

1. Steuerungssystem (100) der Entladephase der Lade/Entlade-Zyklen einer Batterie, dafür bestimmt, um mit einer wiederaufladbaren Batterie mit Ladephasen, die mit Entladephasen entsprechend Lade/Entlade-Zyklen abwechseln, verknüpft zu werden, wobei dieses System enthält:

Erste adaptive Rechenmittel (NN1A, NN1B), die ausgelegt sind, um in einem Initialzeitpunkt (to) bei Beginn einer Entladephase eines Lade/Entlade-Zyklus der Batterie einen vorbestimmten Grenzwert einer kritischen Entladespannung ($V_{TH}$) zu sammeln und um eine voraussagende Angabe über einen kritischen Zeitpunkt ($t_{TH}$) zu berechnen und auszugeben, in dem die Batterie diesen vorbestimmten kritischen Grenzwert ($V_{TH}$) der Entladespannung erreicht,
zweite adaptive Rechenmittel (NN2A, NN2B), die mit den ersten Rechenmitteln verknüpft und ausgelegt sind, um in einem Initialzeitpunkt (to) eine Messung einer Initialspannung (Vo), einer Initialvariation ($\Delta$Vo) der Spannung in einem neuen Zeitpunkt t'o nach einem kurzen Zeitraum ($\Delta$to) ausgehend von diesem Initialzeitpunkt (to) und der Initialanzahl (No) der mit dieser Batterie vor diesem Initialzeitpunkt (to) bereits ausgeführten Lade/ Entlade-Zyklen zu sammeln und um ab dem Zeitpunkt to + ∆to der betreffenden Phase, in dem die Initialmessungen zur Verfügung stehen,

Funktionsparameter zu berechnen und auszugeben, die automatisch an die Werte der Initialmessungen angepasst werden, um sie den ersten Rechenmitteln vorzugeben.

2. Steuerungssystem nach Anspruch 1, in dem die ersten adaptiven Rechenmittel (NN1A, NN1B) außerdem ausgelegt sind, um in einem laufenden Zeitpunkt (t) in der betreffenden Entladephase des laufenden Lade/Entlade-Zyklus der Batterie eine Messung der Temperatur ($T_t$) zu sammeln und um in diesem laufenden Zeitpunkt (t) eine voraussagende Angabe eines kritischen Zeitpunkts ($t_{TH}$) zu berechnen und auszugeben, in dem die Batterie den vorbestimmten Grenzwert der Entladespannung ($V_{TH}$) erreicht.

3. Steuerungssystem nach einem der Ansprüche 1 oder 2, in dem:

Die ersten adaptiven Rechenmittel außerdem ausgelegt sind, um in jedem laufenden Zeitpunkt (t) eine voraussagende Angabe des Zeitraums (∆tTH) zu berechnen und auszugeben, der ab diesem laufenden Zeitpunkt (t) bis zu dem kritischen Zeitpunkt ($t_{TH}$) verbleibt, in dem die Batterie den vorbestimmten kritischen Grenzwert der Entladespannung ($V_{TH}$) erreicht, oder um eine voraussagend Angabe dieses kritischen Zeitpunkts ($t_{TH}$) auszugeben.

4. Steuerungssystem nach Anspruch 1, in dem die Rechenmittel gebildet werden aus:

Einem ersten Neuronennetz (NN1A), das angeordnet ist, um in jedem laufenden Zeitpunkt (t) ausgehend von dem vorbestimmten kritischen Grenzwert der Entladespannung ($V_{TM}$) eine voraussagende Angabe des kritischen Zeitpunkts ($T_{TH}$) zu berechnen und auszugeben, in dem die Batterie den vorbestimmten kritischen Grenzwert der Entladespannung ($V_{TH}$) erreicht, einem zweiten Neuronennetz (NN2A), mit dem ersten Neuronennetz in Serie geschaltet und angeordnet, um ausgehend von der Messung der initialen Spannungswerte (Vo), der Initialvariation der Spannung (∆Vo) und der Initialanzahl an Zyklen (No) bei jedem Beginn der Entladephase jedes Entladezyklus ab dem Zeitpunkt (to + ∆to) der betreffenden Phase, in dem die Initialmessungen zur Verfügung stehen, synaptische Stellenwerte (WjB) zu berechnen und auszugeben, die automatisch angepasst werden, um sie dem ersten Neuronennetz vorzugeben.

5. Steuerungssystem nach Anspruch 2, in dem die Rechenmittel gebildet werden aus:

Einem ersten Neuronennetz (NN1B), das angeordnet ist, um in jedem laufenden Zeitpunkt (t) ausgehend von dem vorbestimmten kritischen Grenzwert der Entladespannung ($V_{TH}$) und ausgehend von der Temperaturmessung ($T_t$) eine voraussagende Angabe des kritischen Zeitpunkts ($T_{TH}$) zu berechnen und auszugeben, in dem die Batterie den vorbestimmten kritischen Grenzwert der Entladespannung ($V_{TH}$) erreicht, einem zweiten Neuronennetz (NN2B), mit dem ersten Neuronennetz in Serie geschaltet und angeordnet, um ausgehend von der Messung der initialen Spannungswerte (Vo), der Initialvariation der Spannung (∆Vo) und der Initialanzahl an Zyklen (No) bei jedem Beginn der Entladephase jedes Entladezyklus ab dem Zeitpunkt to + ∆to der betreffenden Phase, in dem die Initialmessungen zur Verfügung stehen, synaptische Stellenwerte (WjB) zu berechnen und auszugeben, die automatisch angepasst werden, um sie dem ersten Neuronennetz vorzugeben.

6. Steuerungssystem nach einem der Ansprüche 4 oder 5, in dem:

Das erste Neuronennetz (NN1A, NN1B) angeordnet ist, um in jedem laufenden Zeitpunkt (t) ausgehend von dem vorbestimmten kritischen Grenzwert der Entladespannung ($V_{TH}$) und eventuell ausgehend von der Temperaturmessung ($T_t$) eine voraussagende Angabe des Zeitraums (∆$t_{TH}$) zu berechnen und auszugeben, der bis zu dem kritischen Zeitpunkt ($t_{TH}$) verbleibt, in dem die Batterie diesen vorbestimmten kritischen Grenzwert der Entladespannung ($V_{TH}$) erreicht.

7. Steuerungssystem nach einem der Ansprüche 4 bis 6, in dem das erste Neuronennetz drei Schichten hat, worunter eine Schicht von zwei oder drei Eingangsschwellen für einen respektiven Grenzwert, einen Spannungswert und eventuell einen Temperaturwert, eine Schicht versteckter Zellen und einer Ausgangszelle, wobei die Zellen der versteckten Schicht eine Sigma-Aktivierungsfunktion mit unterschiedlicher Neigung von einer zur anderen Zelle haben und die Zelle der Ausgangsschicht eine lineare Aktivierungsfunktion hat.

**8.** Steuerungssystem nach Anspruch 7, in dem das zweite Neuronennetz drei Schichten mit neuronalen Zellen, worunter eine Eingangsschicht mit vier Eingangszellen für respektive einen Grenzwert, und jeder der Initialwerte eine Schicht versteckter Zellen und eine Schicht Ausgangszellen hat, wobei die Zellen der versteckten Schicht eine Sigma-Aktivierungsfunktion mit unterschiedlicher Neigung von einer zur anderen Zelle haben und die Zellen der Ausgangsschicht in der Anzahl den synaptischen Koeffizienten entsprechen, die für die Funktionsweise des ersten Neuronennetzes erforderlich sind und eine Sigma-Aktivierungsfunktion haben.

**9.** Steuerungssystem nach einem der Ansprüche 1 bis 8 wobei dieses System (100) an eine wiederaufladbare Batterie (110), an Mittel zum Messen der Zeit (150a), zum Messen der Spannung (150b), eventuell an Mittel zum Messen der Temperatur und an Anzeigemittel (140) gekoppelt ist, die angeordnet sind, um entweder eine Anzeige des kritischen Zeitpunkts ($t_{TH}$) auszugeben, in dem die Batterie den kritischen Spannungsgrenzwert ($Vt_{TH}$) erreicht, oder eine Anzeige des Zeitraums ($\Delta t_{TH}$) der ausgehend von einem laufenden Zeitpunkt (t) der Anwendung bis zu dem Zeitpunkt ($t_{TH}$) verbleibt, in dem die Batterie einen vorbestimmten kritischen Spannungsgrenzwert ($Vt_{TH}$) erreicht, oder auch beide Anzeigen und eventuell eine Anzeige des Endes der Wiederaufladephase der Batterie.

**10.** Steuerungssystem nach Anspruch 9 mit:

Einem Mikroprozessor (160) zum Ausführen von Berechnungen, und Speicherzonen (170a, 170b) zum Abspeichern von Daten, wobei diese Speicherzonen für den Mikroprozessor (160) zugänglich sind und eine Speicherzone (170a) zum Abspeichern der Strukturdaten der Neuronennetze, der festen Parameter und der synaptischen Koeffizienten des zweiten Neuronennetzes einschließen, und eine Arbeitsspeicherzone (170b) zum Aufzeichnen oder Ausgeben der variablen Messungen und der synaptischen Koeffizienten des ersten Neuronennetzes beinhalten.

**11.** Zugehörige Vorrichtung (130) mit einem Steuerungssystem nach einem der Ansprüche 9 oder 10, wobei diese zugehörige Vorrichtung von einer wiederaufladbaren Batterie versorgt wird, mit der das besagte Steuerungssystem verknüpft ist.

**12.** Lernverfahren für Neuronennetze des Steuerungssystems nach einem der Ansprüche 7 oder 8 mit in einer Lernphase:

- Das Erlernen vom ersten Neuronennetz von Kurven der Entladezeit (t) unter Berücksichtigung der Entladespannung (Vt) und eventuell der Temperatur (Tt) als Parameter, während Entladespannungen (Vt) am Eingang des ersten Neuronennetzes vorgegeben werden, normalerweise für den Spannungswert bestimmt, und der entsprechenden Zeiten am Ausgang, um eine Datenbank zu bilden, die aus Vektoren der synaptischen Koeffizienten (WjA, WjB) dieses ersten Neuronennetzes gebildet werden,
- das Erlernen vom zweiten Neuronennetz von Relationen zwischen den Initialwerten (Vo, $\Delta$Vo, No) und den synaptischen Koeffizienten (WjA, WjB), beim Erlernen des ersten Neuronennetzes berechnet, um seine eigenen synaptischen Koeffizienten zu bestimmen und festzulegen.

**Claims**

**1.** A monitoring system for monitoring the discharge phase of the charge/discharge cycles of a battery, intended to be coupled to a rechargeable battery which has charge periods alternating with discharge phases as a function of charge/discharge cycles, this system comprising:

first adaptive calculation means (NN1A, NN1B) which are arranged for collecting, at an initial instant (to) at the beginning of a discharge phase of a charge/discharge cycle of the battery, a predetermined value of a critical discharge voltage threshold ($V_{TH}$), and for calculating and providing a predictive indication of a critical instant ($t_{TH}$) at which the battery will reach this predetermined critical discharge voltage threshold ($V_{TH}$), second adaptive calculation means (NN2A, NN2B) coupled to the first calculation means, which are arranged for collecting, at the initial instant (to), a measured value of an initial voltage (Vo), of an initial variation ($\Delta$Vo) of the voltage at a later instant (t'o) after a short lapse of time ($\Delta$to) starting from this initial instant (to) onwards, and of the initial number (No) of charge/discharge cycles of this battery effected before this initial instant (to), and arranged for calculating and producing from the instant, to+$\Delta$to, of said discharge phase at which the initial values are available onwards, operating parameters which are automatically adapted to the values of the initial measurements and imposed on the first calculation means.

2. A monitoring system as claimed in Claim 1, in which the first adaptive calculation means (NN1A, NN1B) are also arranged for collecting, at a current instant (t) during the respective discharge phase of the charge/discharge cycle of the battery in operation, a temperature measurement (Tt), and for calculating and providing at this current instant (t) a predictive indication of a critical instant ($t_{TH}$) at which the battery will reach the predetermined critical discharge voltage threshold ($V_{TH}$).

3. A monitoring system as claimed in one of the Claims 1 or 2, in which:

the first adaptive calculation means are also arranged for calculating and providing at each current instant (t) a predictive indication of the lapse of time ($\Delta t_{TH}$) that is left from this current instant (t) onwards until the critical instant ($t_{TH}$) at which the battery will reach the predetermined critical discharge voltage threshold ($V_{TH}$), or a predictive indication of this critical instant ($t_{TH}$).

4. A monitoring system as claimed in Claim 1, in which the adaptive calculation means are formed by:

a first neural network (NN1A) arranged for calculating and providing at each current instant (t) a predictive indication of the critical instant ($t_{TH}$) at which the battery will reach this predetermined critical discharge voltage threshold ($V_{TH}$), on the basis of the predetermined critical discharge voltage threshold ($V_{TH}$),
a second neural network (NN2A), combined in series with the first neural network, arranged for calculating and providing automatically adapted synaptic weights (WjB) imposed on the first neural network, on the basis of the initial measurement of the voltage values (Vo), of the initial voltage variation ($\Delta$Vo) and of the initial number of cycles (No), with each start of a discharge phase of each discharge cycle, from the instant (to+$\Delta$to) of the respective period onwards at which the initial measurements are available.

5. A monitoring system as claimed in Claim 2, in which the adaptive calculation means are formed by:

a first neural network (NN1B) arranged for calculating and providing at each current instant (t) a predictive indication of the critical instant ($t_{TH}$) at which the battery will reach this predetermined critical discharge voltage threshold ($V_{TH}$), on the basis of the predetermined critical discharge voltage threshold ($V_{TH}$), and on the basis of the temperature measurement (Tt),
a second neural network (NN2B), combined in series with the first neural network, arranged for calculating and providing automatically adapted synaptic weights (WjB) imposed on the first neural network, on the basis of the initial measurement of the voltage values (Vo), of the initial voltage variation ($\Delta$Vo) and of the initial number of cycles (No), with each start of a discharge phase of each discharge cycle, from the instant, to+$\Delta$to, of the respective period onwards at which the initial measurements are available.

6. A monitoring system as claimed in one of the Claims 4 or 5, in which:

the first neural network (NN1A,NN1B) is arranged for calculating and providing at each current instant (t) a predictive indication of the lapse of time ($\Delta t_{TH}$) that is left from this current instant (t) onwards until the critical instant ($t_{TH}$) at which the battery will reach this predetermined critical discharge voltage threshold ($V_{TH}$), on the basis of the predetermined critical discharge voltage threshold ($V_{TH}$), and optionally on the basis of the temperature measurement (Tt).

7. A monitoring system as claimed in one of Claims 4 to 6, in which the first neural network (NN1) has three layers, of which one layer of two or three input cells for a threshold, a voltage value and optionally a temperature value respectively, one layer of hidden cells and an output cell, the cells of the hidden layer having a sigmoidal activating function with different slopes from one cell to another, and the cell of the output layer having a linear activating function.

8. A monitoring system as claimed in Claim 7, in which the second neural network has three neural cell layers, of which one layer of four input cells for a threshold, and each of the initial values respectively, one layer of hidden cells, and one layer of output cells, the cells of the hidden layer having a sigmoidal activating function with different slopes from one cell to another, and the cells of the output layer having a like quantity to the number of synaptic coefficients which are necessary for the operation of the first neural network and having a sigmoidal activating function.

9. A monitoring system as claimed in one of Claim 1, this system (100) being coupled to a rechargeable battery (110), to time measuring means (150a), voltage measuring means (150b), and optionally to temperature measuring means (150c), and to display means (140) arranged for providing either an indication of the critical instant ($t_{TH}$) at which the battery will reach the critical voltage threshold ($vt_{TH}$), or an indication of the lapse of time ($\Delta t_{TH}$) that is left from a current instant of use (t) onwards until the instant ($t_{TH}$) at which the battery will reach a predetermined critical voltage threshold ($Vt_{TH}$), or the two indications, and optionally an indication of the end of the recharge period of the battery.

10. A monitoring system as claimed in Claim 9, comprising a microprocessor (160) for carrying out the calculations, and memory areas (170a, 170b) for storing the data, these memory areas being accessible via the microprocessor (160) and including a ROM memory area (170a) for storing the structure data of the neural networks, the fixed parameters and the synaptic coefficients of the second neural network, and a RAM memory area (170b) for recording or producing the variable measurements and the synaptic coefficients of the first neural network.

11. A host device (130) comprising a monitoring system as claimed in one of the Claims 9 or 10, this host device being fed by the rechargeable battery which is coupled to said monitoring system.

12. A method of producing neural networks of the monitoring system as claimed in one of the Claims 7 or 8, comprising in a learning period:

- the learning by the first neural network, of discharge time curves (t) as a function of the discharge voltage (Vt) and optionally the temperature (Tt) as parameters, during which period discharge voltages (Vt) are imposed on the input of the first neural network normally intended for the voltage value, and the corresponding instants are imposed on the output for forming a data base formed by vectors of the synaptic coefficients (WjA,WjB) of this first neural network,

- the learning by the second neural network of relations between the initial values (Vo, $\Delta$Vo, No) and the synaptic coefficients (WjA,WjB) determined in its learning period of the first neural network, for determining and fixing its own synaptic coefficients.

$V_{TH}, (V_t) \rightarrow$ | NN1A | $\rightarrow t_{TH}, (t)$

$V_0 \rightarrow$
$\Delta V_0 \rightarrow$ | NN2A |
$N_0 \rightarrow$

$W_j A$

## FIG.1A

$V_{TH}, (Vt) \rightarrow$
$T \rightarrow$ | NN1B | $\rightarrow t_{TH}, (t)$

$V_0 \rightarrow$
$\Delta V_0 \rightarrow$ | NN2B |
$N_0 \rightarrow$

$W_j B$

## FIG.1B

FIG.2A

EP 0 772 055 B1

FIG.2B

21

FIG.3A

FIG.3B

FIG.4 A

FIG.4B

FIG. 4 C

FIG. 4 D

150a

t    t₀    t₀'    110    t    150c

150b

Vt    V₀    V₀'    Tt    t

Δt TH
t TH

160

**FIG.5A**

N₀    V₀    ΔV₀    t TH    (Vt)    V TH    Tt

160,
170

160,
170

NN2A,
NN2B    WjA
WjB    NN1A,
NN1B

FIG.5B

FIG.6A

FIG.6B